# EUROPEAN PATENT APPLICATION

(11) **EP 4 443 298 A1**
(43) Date of publication of application: **09.10.2024**
(21) Application number: 23204125.1
(22) Date of filing: 17.10.2023
(51) Int. Cl.: G06F 11/10

(54) **ADAPTIVE MEMORY METADATA ALLOCATION**

(30) Priority: 07.04.2023 US 202318131980
(71) Applicant: INTEL Corporation, Santa Clara, CA 95054 (US)
(72) Inventor: KUMAR, Karthik, Chandler, 85249 (US); GUIM BERNAT, Francesc, 08036 Barcelona (ES); KRITHIVAS, Ramamurthy, Gilbert, 85298 (US)
(74) Representative: Rummler, Felix

(57) **Abstract**

Techniques for adaptive memory metadata allocation. A processor may determine a first memory region of a plurality of memory regions in a memory pool coupled to the processor via an interface. The processor may modify a metadata of the first memory region from a first configuration to a second configuration, where the first configuration is associated with a first number of error correction code (ECC) bits and the second configuration is associated with a second number of ECC bits.

## Description

### BACKGROUND

Physical memory may be shared among multiple hardware and/or software entities. However, different entities may require different memory functionalities. Conventional solutions may apply these functionalities equally across the shared memory, which may preclude the ability to provide varied memory functionalities in shared memory.

### BRIEF DESCRIPTION OF THE SEVERAL VIEWS OF THE DRAWINGS

To easily identify the discussion of any particular element or act, the most significant digit or digits in a reference number refer to the figure number in which that element is first introduced.
FIG. 1 illustrates an aspect of the subject matter in accordance with one embodiment.
FIG. 2 illustrates an aspect of the subject matter in accordance with one embodiment.
FIG. 3 illustrates an aspect of the subject matter in accordance with one embodiment.
FIG. 4 illustrates an aspect of the subject matter in accordance with one embodiment.
FIG. 5 illustrates a logic flow 500 in accordance with one embodiment.
FIG. 6 illustrates an aspect of the subject matter in accordance with one embodiment.

### DETAILED DESCRIPTION

Embodiments disclosed herein provide techniques for adaptive memory metadata allocation. Memory may be associated with configuration metadata, where the configuration metadata indicates which services are applied to the memory. For example, the services may include error correcting code (ECC) services, encryption services, isolation services, memory tiering, directory tracking, and/or protocol services. However, the configuration metadata is limited (e.g., 10 bits in some examples). Therefore, the configuration metadata cannot be used to support all services at all times. For example, ECC can be implemented at varying levels, with some levels requiring more metadata bits than others. Therefore, using ECC may preclude the use of other services, as the ECC metadata may consume some (or all) of the metadata bits. Similarly, the use of other services may preclude the use of ECC, as the other services may consume some (or all) of the metadata bits.

Embodiments disclosed herein provide a flexible scheme for memory configuration metadata allocation. The memory configuration metadata may be allocated on different ranges of memory addresses of physical memory. Such ranges of physical memory may be spread across multiple elements of physical memory, e.g., multiple elements of physical memory in a memory pool. In cloud computing environments where different tenants have different memory requirements, embodiments disclosed herein allow each tenant to apply one or more desired memory metadata allocations. For example a first tenant may have stringent security requirements. As such, the memory metadata allocation for the first tenant may allocate more bits to encryption and/or isolation services, with few (or no) bits allocated to ECC. As another example, a second tenant may allocate all metadata bits to ECC coverage. Embodiments are not limited in these contexts.

Over time, memory may fail or otherwise encounter errors. Therefore, embodiments disclosed herein may monitor the use of memory over time to track error rates. The error rates may be tracked across memory address regions within a memory pool and across a set of memory pools in a data center. Based on the tracked error rates, embodiments disclosed herein may identify memory address regions that have high error rates, and allocate memory metadata bits to ECC for maximum ECC coverage. More generally, for any memory region, embodiments disclosed herein may compute probability values reflecting a probability (or likelihood) that the memory region may return errors (or otherwise fail). In some embodiments, the memory metadata allocation for a given memory region may be based on the probability values for the region. For example, if the probability value indicates a low likelihood of errors for a first memory region, embodiments disclosed herein may allocate fewer metadata bits to ECC and allocate other metadata bits to other services.

Embodiments disclosed herein may expand system components (e.g., memory controllers, caching agents, operating system (OS), applications, etc.) to support new types of address spaces that may have different memory metadata allocations. Furthermore, quality of service (QoS) hooks may be expanded to understand the new types of address spaces having different memory metadata allocations. For example, if an application requires a desired amount of bandwidth, the QoS hooks may provide the proper interleaving across memory pools to achieve the desired amount of bandwidth.

Reference is now made to the drawings, wherein like reference numerals are used to refer to like elements throughout. In the following description, for purposes of explanation, numerous specific details are set forth in order to provide a thorough understanding thereof. However, the novel embodiments can be practiced without these specific details. In other instances, well known structures and devices are shown in block diagram form in order to facilitate a description thereof. The intention is to cover all modifications, equivalents, and alternatives consistent with the claimed subject matter.

In the Figures and the accompanying description, the designations "a" and "b" and "c" (and similar designators) are intended to be variables representing any positive integer. Thus, for example, if an implementation sets a value for a = 5, then a complete set of components 121 illustrated as components 121-1 through 121-a may include components 121-1, 121-2, 121-3, 121-4, and 121-5. The embodiments are not limited in this context.

Operations for the disclosed embodiments may be further described with reference to the following figures. Some of the figures may include a logic flow. Although such figures presented herein may include a particular logic flow, it can be appreciated that the logic flow merely provides an example of how the general functionality as described herein can be implemented. Further, a given logic flow does not necessarily have to be executed in the order presented unless otherwise indicated. Moreover, not all acts illustrated in a logic flow may be required in some embodiments. In addition, the given logic flow may be implemented by a hardware element, a software element executed by a processor, or any combination thereof. The embodiments are not limited in this context.

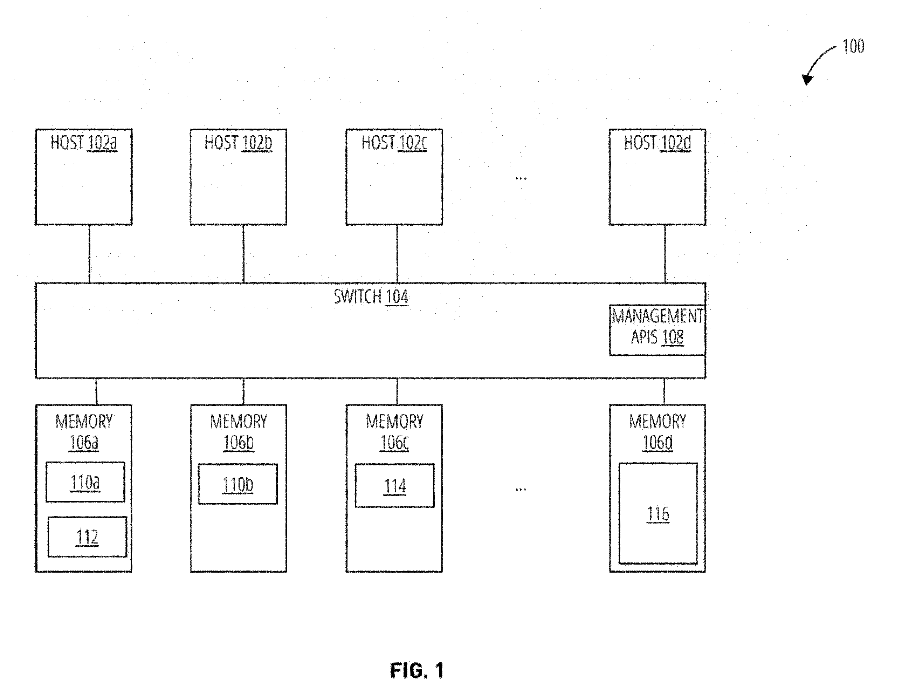

FIG. 1 depicts an example computing system 100 that implements memory pooling. The memory pooling implemented by the computing system 100 may be according to various architectures, such as the Compute Express Link (CXL) architecture. The CXL architecture may be based on a Peripheral Component Interconnect-enhanced (PCIe) physical layer and provides a respective common memory space for each of a plurality of hosts 102a-102d of the computing system 100. The hosts 102a-102d are representative of any type of physical and/or virtualized computing system. As shown, a switch 104 couples the hosts 102a-102d to a plurality of memory devices including memory 106a-memory 106d. The switch 104 may be a CXL switch and may provide one or more management APIs 108 to implement memory pooling.

Generally, a memory pool is one or more regions of memory, where each region includes a range of one or more memory addresses. The regions of memory in a memory pool may span across multiple memory devices. Furthermore, a given memory device may be shared among multiple hosts 102a-102d. In some embodiments, a memory device may be shared by 16 hosts. In some embodiments, a single memory device is allocated to a single host. More generally, memory pools may be dynamically allocated and deallocated based on need. For example, software executing on host 102a may request, via the management APIs 108, a memory pool. The management APIs 108 may then cause the switch 104 to allocate a memory pool to the host 102a. The software may subsequently request, via the management APIs 108, deallocation of the memory pool. The management APIs 108 may then cause the switch 104 to deallocate the memory pool from the host 102a.

As shown in FIG. 1, memory 106a includes a memory region 110a and a memory region 112, memory 106b includes a memory region 110b, memory 106c includes a memory region 114, and memory 106d includes a memory region 116. Therefore, in one example, a first memory pool may include memory regions 110a and 110b, which may be allocated to a host such as host 102a. A second memory pool may include memory region 112 and may be allocated to host 102b. A third memory pool may include memory region 114 and may be allocated to host 102c. A fourth memory pool may include memory region 116, which may be allocated to host 102d. Embodiments are not limited in this context.

Often, different services may be applied to memory 106a-106d. Example services include, but are not limited to, ECC services, encryption services, isolation services, memory tiering, directory tracking, and/or protocol services. Encryption services may encrypt the data in memory. Example encryption services include Intel^{®} Software Guard Extensions (SGX), AMD^{®} Secure Memory Encryption (SME), the Arm^{®} Confidential Compute Architecture. Isolation services may isolate memory from different tenants and may include the Intel Trust Domain Extensions (TDX), Arm TrustZone^{®}, AMD Secure Encrypted Virtualization (SEV), and AMD Secure Encrypted Virtualization-Encrypted State (SEV-ES). Memory tiering may create one or more tiers of memory, e.g., where one tier may include different types of memory (e.g., with different performance characteristics such as speed, latency, etc.) than another tier. Examples of memory tiering include the Intel Optane technologies and the AMD Radeon^{™} RAMDisk. Directory tracking services may handle coherence between distributed memory (e.g., between different memory pools across the memory 106a-106d). Example protocol services may include protocols to support the Intel Universal Path Interconnect (UPI). Embodiments are not limited in these contexts.

Conventionally, services are uniformly applied to the memory 106a-106d and/or any memory pools created thereon. However, embodiments disclosed herein permit the application of different services across different memory regions, different memory ranges, different virtual address spaces, different memory pools, and/or different physical memory elements. To do so, embodiments disclosed herein leverage memory metadata to indicate which services among a plurality of services are applied to the memory. However, since memory metadata is limited, in some embodiments, not all available services can be applied to memory. For example, using ECC on memory region 112 may preclude the use of one or more other services in the memory region 112, as ECC requires one or more bits of memory data.

Therefore, for example, encryption and ECC services may be applied to memory region 110a, while encryption services and isolation services may be applied to memory region 110b. As another example, a first level of ECC services may be applied to memory region 112 and a second level of ECC services may be applied to memory region 116. Different levels of ECC services may be based on the number of bits allocated to ECC, where more bits allocated to ECC provide greater ECC coverage in the memory 106a-106d than fewer ECC bit allocations. As stated, the metadata of the memory may be modified to reflect the allocation of services from a plurality of services to the memory.

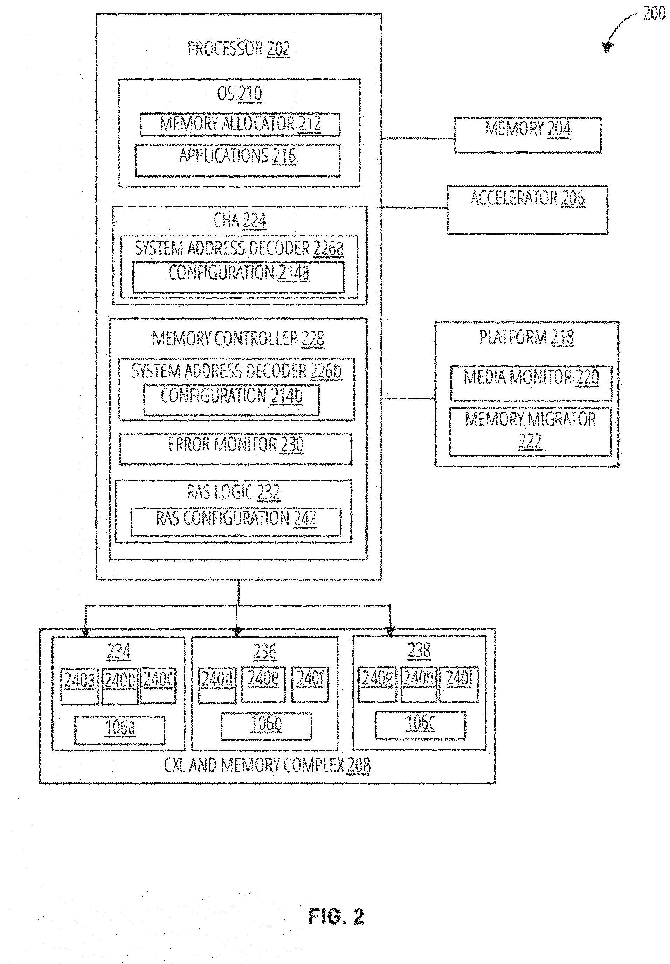

FIG. 2 illustrates a computing system 200 configured to implement adaptive memory metadata allocation, according to one example. As shown, the computing system 200 includes a processor 202 coupled to memory 204, an accelerator 206, a platform 218, and a CXL and memory complex 208, each of which may be implemented in circuitry and/or a combination of circuitry and software. The CXL and memory complex 208 may include the switch 104 and other elements of computing system 100, which are not pictured in FIG. 2 for clarity. The accelerator 206 may be a data copy accelerator (also referred to as a data streaming accelerator). One example of an accelerator 206 is the Intel Data Streaming Accelerator (DSA).

The platform 218 is generally configured to manage memory metadata and/or memory service allocation in the computing system 200. For example, the platform 218 may be software and/or hardware to include a media monitor 220 to monitor the use or other attributes (e.g., age, error rates, etc.) of the memory 106a-106d in the CXL and memory complex 208. The memory migrator 222 may be configured to cause data to be migrated from a first memory location to a second memory location in the CXL and memory complex 208.

The CXL and memory complex 208 is representative of the configuration depicted in FIG. 1. For example, the CXL and memory complex 208includes the switch 104 (not pictured for clarity). The CXL and memory complex 208 includes various memory pool entities, including pooled memory node 234, local memories 236, and devices or other memory 238. Pooled memory node 234 may include memory pools 240a-240c built at least in part on memory 106a. Local memories 236 may include memory pools 240d-240f built at least in part on memory 106b. Devices or other memory 238 may include memory pools 240g-240i built at least in part on memory 106c. Embodiments are not limited in this context.

As shown, the processor 202 executes an operating system (OS) 210. The OS 210 may be any type of operating system. The OS 210 includes a memory allocator 212 to allocate, deallocate, or otherwise manage memory pools in the CXL and memory complex 208 for one or more applications 216. In some embodiments, the applications 216 may execute on other systems (e.g., one of the hosts 102a-102d communicably coupled to the computing system 200). Therefore, the OS 210 and/or applications 216 on other hosts may transmit requests to the computing system 200 via one or more APIs, e.g., the management APIs 108 of the switch 104.

The caching home agent 224 may handle memory management operations for the processor 202. For example, if the processor 202 issues a request to access a first memory address, the caching home agent 224 may redirect or otherwise translate the request such that the appropriate memory address is accessed. More generally, the caching home agent 224 may resolve coherency across multiple processors and snoop requests from processor cores and/or local or remote agents. The address space of the CXL and memory complex 208 may be interleaved across different caching home agents 224, which collectively act as a single logical caching home agent 224. The caching home agent 224 includes an instance of a system address decoder 226a. As the memory controller 228 includes a corresponding instance of the system address decoder 226b. The memory controller 228 generally handles access to the memory in the CXL and memory complex 208.

In some embodiments, the OS 210 may define a plurality of virtual memory spaces. The OS 210 may map the virtual memory spaces to respective elements of physical memory, e.g., memory 106a-106d. For example, the OS 210 may define a first virtual memory space and map the first virtual memory space to a physical memory region, such as memory region 112. Similarly, the OS 210 may define a second virtual memory space and map the second virtual memory space to a physical memory region, such as memory region 114. The OS 210 may store the mappings in a page table in a translation lookaside buffer (TLB), e.g., a TLB of the processor 202. Furthermore, the OS 210 may allocate different sets of memory resources for the virtual memory spaces. The OS 210 may further define metadata (e.g., configuration 214a and/or configuration 214b) for different features for each virtual memory space that is applied to the virtual memory space and/or the underlying physical memory regions.

The system address decoders 226a, 226b, are expanded to support different address spaces with different service configurations for different memory configurations (e.g., virtual memory spaces, physical memory ranges, physical memory tiers, physical memory pools, etc.). The address spaces may be physical address spaces and/or virtual address spaces. The service configurations may be applied to the virtual address spaces and/or the physical address spaces. The system address decoders 226a, 226b may include memory metadata for a given memory configuration. The service configurations for a given address space may be configured statically and/or adaptively. In some embodiments, a privileged entity (e.g., ring 0 or root privileges in the OS 210) may be required to configure service configurations for memory. In some embodiments, different service configurations may include predetermined sets of different memory services.

For example, a first memory range (e.g., memory region 110a) may be focused on resiliency due to the age of the media (e.g., memory 106a). The first memory range may be a physical memory range and/or a virtual memory range that is mapped to a physical memory range. In such an example, the services applied to the first memory range include maximum ECC bit coverage. Doing so may consume all metadata bits for the first memory range, leaving no additional metadata bits for other services for the first memory range. As another example, a second memory range (e.g., memory region 112) may be focused on resiliency due to the usage mode. The second memory range may be a physical memory range and/or a virtual memory range that is mapped to a physical memory range. In such an example, the services applied to the second memory range include maximum ECC bit coverage. Doing so may consume all metadata bits for the second memory range, leaving no additional metadata bits for other services for the second memory range.

As another example, a third memory range (e.g., memory pool 240a) may be focused on security. The third memory range may be a physical memory range and/or a virtual memory range that is mapped to a physical memory range. Therefore, in such an example, encryption services, isolation services, and reduced ECC services may be applied to the third memory range. Doing so provides less ECC bit coverage than the first and second memory ranges, but provides the encryption and isolation services. As another example, a fourth memory range (e.g., memory pool 240d) may be focused on scalability. The fourth memory range may be a physical memory range and/or a virtual memory range that is mapped to a physical memory range. Therefore, services allocated to the fourth memory range may include UPI and ECC services, while not including encryption and/or isolation services. Since some metadata bits may be allocated to UPI, full ECC bit coverage may not be provided to the fourth memory range.

As stated, the metadata coverage (and the services applied) to memory may be configured adaptively. For example, a tenant may specify to allocate encryption services to the first memory range, thereby reducing the ECC bit coverage for the first memory range. To do so, embodiments disclosed herein may update the memory metadata for the first memory range, e.g., via the management APIs 108. In some embodiments, the adaptive configuration may occur based on different metrics. For example, the expected usage of a memory range may be used to determine which services to apply to the memory range. In some embodiments, the media monitor 220 of the platform 218 may determine the expected use of a given memory range. Therefore, for example, if the expected use of the first memory range exceeds a predetermined threshold, the platform 218 may reduce the number of ECC metadata bits allocated to the first memory range and apply throttling to the first memory range to reduce the use of the first memory range to reduce the likelihood of errors (e.g., by reducing thermal constraints on the memory.

QoS services provided by the computing system 200 may be expanded to understand the new address spaces disclosed herein (e.g., including the variable memory metadata). For example, if an application 216 has bandwidth requirements, resiliency requirements, and isolation requirements, the platform 218 may provide the proper interleaving across memory pools 240a-240i to provide the required bandwidth, resiliency, and/or isolation services. One example of a platform 218 to provide QoS services is the Intel Resource Director Technology (RDT). Other examples of platforms 218 include the AMD^{®} Platform Quality of Service (PQoS) and ARM^{®} QoS Regulators.

As stated, the platform 218 may determine to change the memory metadata configuration for a memory range, e.g., via the management APIs 108 of the switch 104. For example, when the platform 218 may change the memory metadata configuration the media monitor 220 and/or the error monitor 230 of the memory controller 228 identify errors in the memory range exceeding an error threshold. As another example, the platform 218 may change the memory metadata configuration the media monitor 220 and/or determine the age of the media assigned to the memory range exceeds an age threshold. In yet another example, the platform 218 may change the memory metadata configuration by computing a probability value reflecting a likelihood that one or more memory ranges (and/or one or more physical memory units) will return errors (or otherwise fail). The probability value may therefore reflect a predicted error rate for a memory range. The probability value may be based on one or more of the age of the media, a count of previous errors encountered, QoS requirements, thermal conditions of the media, or any other attribute of the memory. In some embodiments, the platform 218 changes the memory metadata configuration based on a determination that the probability value exceeds a probability threshold. In some embodiments, the memory migrator 222 may instruct the accelerator 206 to move data from the memory range to another memory range in the CXL and memory complex 208 based on the platform 218 determining to modify the memory metadata configuration (e.g., to move the data to a memory pool that satisfies the requirements specified by the modified memory metadata configuration).

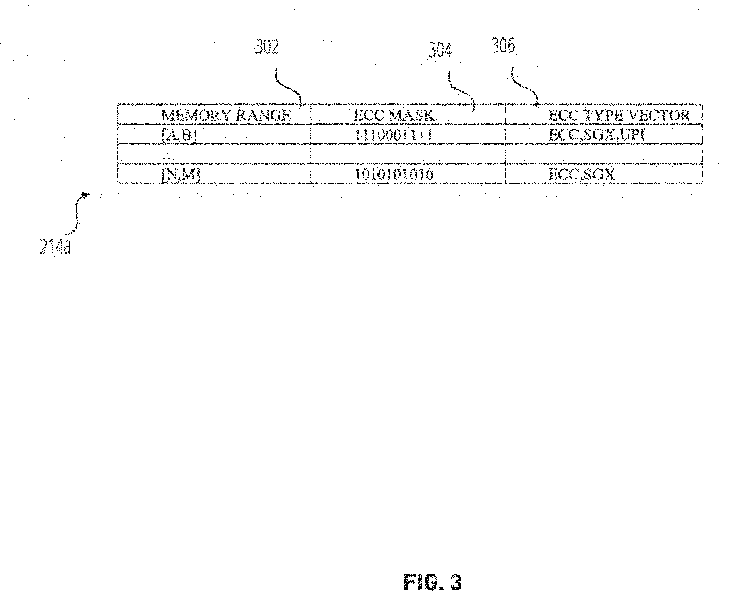

Furthermore, the OS 210 and the applications 216 are configured to use the new address spaces disclosed herein, including variable memory metadata and the associated services provided via the variable memory metadata. The OS 210 (e.g., via the memory allocator 212) is therefore extended to configure different memory address ranges with different metadata configurations to support different sets of services. The OS 210 and/or the memory allocator 212 may transmit memory management requests to the management APIs 108 of the switch 104. The OS 210 may further be configured to determine different types of metadata/service configurations and to extract the vectors (e.g., the ECC mask 304 and/or ECC type vector 306 of FIG. 3). The OS 210 may further be configured to perform memory allocations according to specified criteria. The applications 216 may be configured to request memory allocations according to the correct service configurations given the requirements of the applications 216. For example, an application 216 may ask for 2 gigabytes of memory with encryption services. In response, the memory allocator 212 of the OS 210 may identify (or allocate) 2 gigabytes of memory (which may be spread across multiple elements of memory 106a-106d, e.g., in one or more memory pools 240a-240i) with encryption services and allocate the memory to the requesting application 216.

More generally, the caching home agent 224 and the memory controller 228, via the system address decoders 226a, 226b, respectively, support different address spaces with different service configurations. As shown, system address decoder 226a and system address decoder 226b include configuration 214a, 214b, respectively. FIG. 3 depicts an example of the configuration 214a, which may be the same as the configuration 214b. Stated differently, the configuration 214b may be a copy of the configuration 214a. In some embodiments, the configuration 214a or configuration 214b may be applied to virtual memory spaces that are mapped to physical memory ranges.

As shown in FIG. 3, the configuration 214a includes a memory range 302, an ECC mask 304, and an ECC type vector 306. The memory range 302 defines a memory range, which may include one or more memory addresses, to be tagged with metadata as defined by the ECC mask 304 and/or the ECC type vector 306. In one example, a single range of memory (e.g., a line of memory) may include 64 bits of data and 10 bits of metadata. The ECC mask 304 is a bit vector indicating which metadata bits are associated with ECC services. Therefore, a bit having a value of 1 in the ECC mask 304 indicates ECC services are associated with the corresponding bit. The ECC type vector 306 is a vector which identifies additional services (if any) that are applied to the memory range. In some embodiments, the ECC type vector 306 may include a plurality of vectors, with each vector associated with a respective service of a plurality of services (e.g., encryption services, isolation services, etc.).

Therefore, using the configuration 214a, a combination of ECC and other services may be applied to a given memory range. As stated, the configuration 214b may be a copy of the configuration 214a. Therefore, the memory metadata for all memory ranges (physical and/or virtual memory ranges), memory tiers, and/or memory pools 240a-240i may be maintained by the caching home agent 224 and the memory controller 228.

Returning to FIG. 2, the memory controller 228 may be adapted to manage the new hybrid ECC configurations defined by the configuration 214b. For example, the memory controller 228 is configured to use the correct ECC bits for ECC computation and/or corruption detection based on the configuration 214b of the memory range where the memory line belongs. Therefore, on a memory line access, the memory controller 228 may identify the configuration 214b for the memory line. The memory controller 228 may then use the vector ECC mask 304 and the ECC type vector 306 to extract bits that correspond to the ECC for the memory line. The memory controller 228 may then compute an ECC value based on the memory line. The memory controller 228 may then compare the computed ECC value to the extracted ECC bits from the memory line. If the comparison results in a match, the ECC check may pass. Otherwise, if the comparison does not result in a match, an error may have occurred and the ECC check may fail.

Furthermore, as shown, the error monitor 230 of the memory controller 228 monitors the error rates being observed in the memory 106a-106d. For example, the error monitor 230 may maintain indications of when errors are observed (e.g., based on ECC computations, failed memory accesses, etc.). The error monitor 230 may support finegrained error tracking, allowing the error monitor 230 to track error rates on a per-memory address, per-memory address region, and/or memory pool 240a-240i scale. The error monitor 230 may propagate the monitored information to the computing system 200, including the platform 218 and/or the OS 210.

As shown, a reliability, availability and serviceability (RAS) logic 232 may further monitor the CXL and memory complex 208 for errors, use, and/or other attributes. The RAS logic 232 may include a RAS configuration 242 that may be used to configure memory ranges in the CXL and memory complex 208.

The platform 218 is extended to provide monitoring and migration schemes via the media monitor 220 and the memory migrator 222. Doing so allows the platform 218 to ensure that data is placed on the right type of media, e.g., media that is configured to the appropriate requirements. Generally, the platform 218 includes interfaces to discover all memory ranges and the configuration 214a of each memory range (e.g., via the caching home agent 224 and/or the memory controller 228). Doing so allows the platform 218 to identify the ECC mask 304 and the ECC type vector 306 in the configuration 214a-214b for each of a plurality of memory ranges in the CXL and memory complex 208. The platform 218 is further able to configure a specific metadata configuration for a set of services selected from a plurality of memory services for a particular memory pool 240a-240i and/or memory range within a given memory pool. The platform 218 may permit for static configurations specified by the OS 210, where the OS 210 specifies the ECC mask 304 and the ECC type vector 306 for a given memory range.

The platform 218 may further permit for a dynamically modified configuration based on information collected in the computing system 200. For example, the platform 218 may dynamically modify the configuration 214a for memory pool 240d from a first set of memory services to a second set of memory services. For example, the first set of memory services may include ECC, encryption, and isolation services, and the second set of memory services may include ECC and isolation services. The platform 218 may generally be configured to make these modifications via one or more management APIs 108 provided by the switch 104. As another example, if an application 216 specifies a resiliency requirement, the platform 218 may ensure that the right number of ECC bits are allocated to the memory ranges allocated to the application. For example, if the actual resiliency experienced by the application 216 is below the specified resiliency requirement, the platform 218 may modify the configuration 214a of the application 216 to allocate additional ECC bits to the application 216 (e.g., via the ECC mask 304 and/or the ECC type vector 306). If allocation of additional bits is not possible (e.g., because no additional bits are available to allocate to ECC), the platform 218 may cause the bandwidth of the memory to be throttled to avoid overheating and possible errors.

The media monitor 220 of the platform 218 is configured to monitor errors occurring throughout the various physical media, e.g., memory 106a-106d. At least some of the errors may be reported by the error monitor 230 of the memory controller 228. The media monitor 220 may further gather error information via various direct interfaces. Therefore, the media monitor 220 may modify the service configuration for the memory based on the errors detected in the computing system 200. In some embodiments, the media monitor 220 may compare the error information to one or more thresholds. For example, if the memory 106a has experienced, in one or more time intervals, a number of errors that exceed an error threshold, the media monitor 220 may modify the configuration 214a of the memory 106a to increase the ECC bit coverage of the memory 106a (e.g., via the ECC mask 304 and/or the ECC type vector 306). If there is a change in metadata properties for a given memory range (e.g., no bits are available to be allocated for a desired service), the platform 218 may determine if any address space is impacted such that various QoS service requirements are no longer fulfilled. If the QoS services are not fulfilled, the memory migrator 222 may cause the data to be moved to a new memory location with the correct metadata and/or service configurations (e.g., to provide the correct amount of ECC coverage and/or additional services). In such embodiments, the caching home agent 224 may re-map the address range to the new memory location. Furthermore, the caching home agent 224 may intercept requests for the old memory location and remap these requests to the new memory location.

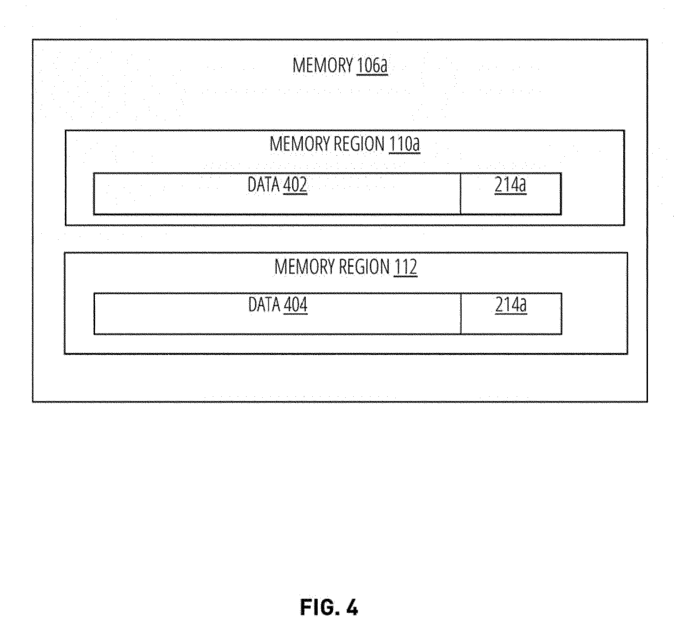

FIG. 4 illustrates an example of adaptive memory metadata allocation. As shown, memory 106a includes two example memory regions, memory region 110a and memory region 112. Memory region 110a and memory regions 112 may belong to the same memory pool or different memory pools. In some embodiments, the OS 210 may create virtual memory spaces that map to memory regions 110a, 110b. As shown, memory region 110a includes one or more lines of data 402, while memory region 112 includes one or more lines of data 402. As shown, the lines of data 402 of memory region 110a are tagged with metadata bits based on configuration 214a, while the lines of data 404 of memory regions 112 are tagged with metadata bits based on configuration 214a.

Therefore, the configuration 214a for data 402 may specify to provide maximum ECC coverage (e.g., based on the ECC mask 304 and/or the ECC type vector 306), while providing no additional memory services. The configuration 214a for data 404 may specify to allocate (via the ECC mask 304 and/or the ECC type vector 306) encryption service, isolation services, UPI services, and fewer ECC bit coverage relative to the maximum ECC coverage provided to data 402.

The configuration 214a for data 402 and data 404 may be specified by the OS 210. As another example, the platform 218 may specify the configuration 214a for data 402 and data 404. As another example, the platform 218 may modify the configuration 214a for data 402 and data 404. For example, if data 402 is stored in new media, the age of the new media may be lower than an age threshold. As another example, the number of errors encountered with the new media may be lower than an error threshold. As such, the platform 218 may modify the configuration 214a of data 402 to allocate fewer bits to ECC and allocate the freed metadata bits to other services such as encryption and/or isolation services (via the ECC mask 304 and/or the ECC type vector 306). As another example, if the memory region 112 experiences errors that exceed an error threshold, the platform 218 may migrate the data 404 to a new memory region, such as memory region 114. The platform 218 may apply the same configuration 214a for data 404 to memory region 114 that was previously applied to memory region 112. Additionally and/or alternatively, the platform may select memory region 114 based on existing configuration 214a that matches the configuration 214a for data 404 that was previously applied to memory region 112. Embodiments are not limited in these contexts.

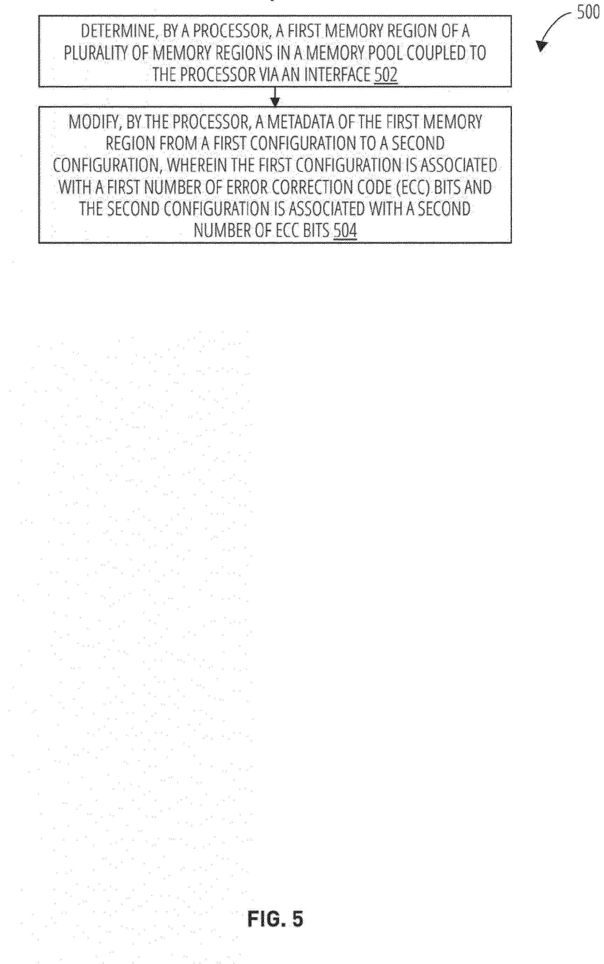

FIG. 5 illustrates a logic flow 500. Logic flow 500 may be representative of some or all of the operations for adaptive memory metadata allocation. Embodiments are not limited in this context.

In block 502, logic flow 500 determines, by a processor, a first memory region of a plurality of memory regions in a memory pool coupled to the processor via an interface. In block 504, logic flow 500 modifies, by the processor, a metadata of the first memory region from a first configuration to a second configuration, wherein the first configuration is associated with a first number of error correction code (ECC) bits and the second configuration is associated with a second number of ECC bits.

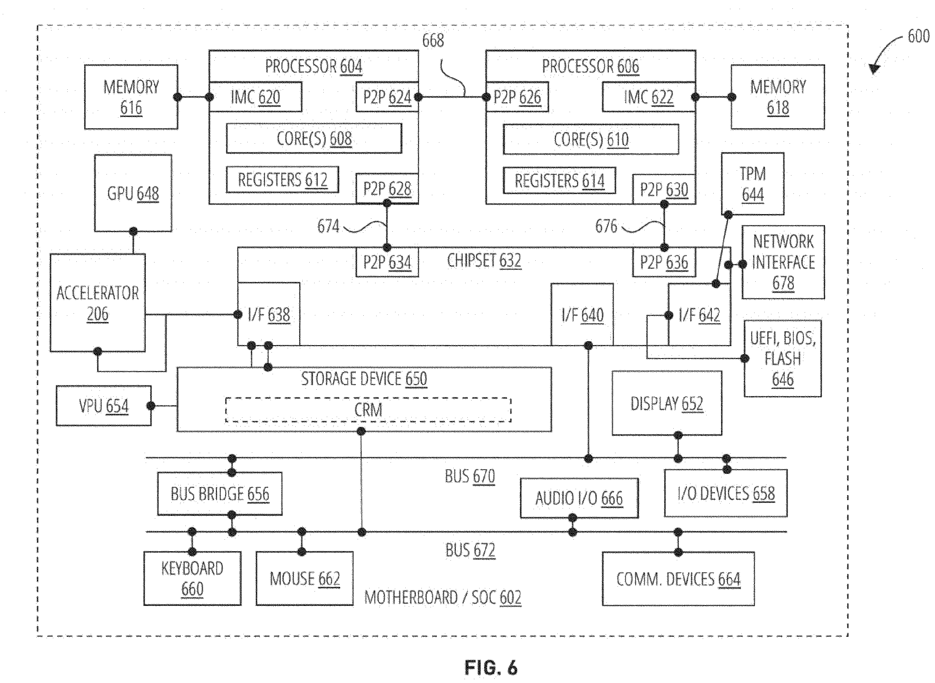

FIG. 6 illustrates an embodiment of a system 600. System 600 is a computer system with multiple processor cores such as a distributed computing system, supercomputer, high-performance computing system, computing cluster, mainframe computer, mini-computer, client-server system, personal computer (PC), workstation, server, portable computer, laptop computer, tablet computer, handheld device such as a personal digital assistant (PDA), or other device for processing, displaying, or transmitting information. Similar embodiments may comprise, e.g., entertainment devices such as a portable music player or a portable video player, a smart phone or other cellular phone, a telephone, a digital video camera, a digital still camera, an external storage device, or the like. Further embodiments implement larger scale server configurations. In other embodiments, the system 600 may have a single processor with one core or more than one processor. Note that the term "processor" refers to a processor with a single core or a processor package with multiple processor cores. In at least one embodiment, the computing system 600 is representative of the components of the computing system 100 and computing system 200. More generally, the computing system 600 is configured to implement all logic, systems, logic flows, methods, apparatuses, and functionality described herein with reference to FIGS. 1-5.

As used in this application, the terms "system" and "component" and "module" are intended to refer to a computer-related entity, either hardware, a combination of hardware and software, software, or software in execution, examples of which are provided by the exemplary system 600. For example, a component can be, but is not limited to being, a process running on a processor, a processor, a hard disk drive, multiple storage drives (of optical and/or magnetic storage medium), an object, an executable, a thread of execution, a program, and/or a computer. By way of illustration, both an application running on a server and the server can be a component. One or more components can reside within a process and/or thread of execution, and a component can be localized on one computer and/or distributed between two or more computers. Further, components may be communicatively coupled to each other by various types of communications media to coordinate operations. The coordination may involve the uni-directional or bi-directional exchange of information. For instance, the components may communicate information in the form of signals communicated over the communications media. The information can be implemented as signals allocated to various signal lines. In such allocations, each message is a signal. Further embodiments, however, may alternatively employ data messages. Such data messages may be sent across various connections. Exemplary connections include parallel interfaces, serial interfaces, and bus interfaces.

As shown in FIG. 6, system 600 comprises a system-on-chip (SoC) 602 for mounting platform components. System-on-chip (SoC) 602 is a point-to-point (P2P) interconnect platform that includes a first processor 604 and a second processor 606 coupled via a point-to-point interconnect 668 such as an Ultra Path Interconnect (UPI). The processors 604, 606 are representative of the processor 202. In other embodiments, the system 600 may be of another bus architecture, such as a multi-drop bus. Furthermore, each of processor 604 and processor 606 may be processor packages with multiple processor cores including core(s) 608 and core(s) 610, respectively. While the system 600 is an example of a two-socket (2S) platform, other embodiments may include more than two sockets or one socket. For example, some embodiments may include a four-socket (4S) platform or an eight-socket (8S) platform. Each socket is a mount for a processor and may have a socket identifier. Note that the term platform may refer to a motherboard with certain components mounted such as the processor 604 and chipset 632. Some platforms may include additional components and some platforms may only include sockets to mount the processors and/or the chipset. Furthermore, some platforms may not have sockets (e.g. SoC, or the like). Although depicted as a SoC 602, one or more of the components of the SoC 602 may also be included in a single die package, a multi-chip module (MCM), a multi-die package, a chiplet, a bridge, and/or an interposer. Therefore, embodiments are not limited to a SoC.

The processor 604 and processor 606 can be any of various commercially available processors, including without limitation an Intel^{®} Celeron^{®}, Core^{®}, Core (2) Duo^{®}, Itanium^{®}, Pentium^{®}, Xeon^{®}, and XScale^{®} processors; AMD^{®} Athlon^{®}, Duron^{®} and Opteron^{®} processors; ARM^{®} application, embedded and secure processors; IBM^{®} and Motorola^{®} DragonBall^{®} and PowerPC^{®} processors; IBM and Sony^{®} Cell processors; and similar processors. Dual microprocessors, multi-core processors, and other multi-processor architectures may also be employed as the processor 604 and/or processor 606. Additionally, the processor 604 need not be identical to processor 606.

Processor 604 includes an integrated memory controller (IMC) 620 and point-to-point (P2P) interface 624 and P2P interface 628. Similarly, the processor 606 includes an IMC 622 as well as P2P interface 626 and P2P interface 630. IMC 620 and IMC 622 couple the processors 604 and 606, respectively, to respective memories (e.g., memory 616 and memory 618). IMC 620 and IMC 622 are representative of memory controller 228. Memory 616 and memory 618 may be portions of the main memory (e.g., a dynamic random-access memory (DRAM)) for the platform such as double data rate type 4 (DDR4) or type 5 (DDR5) synchronous DRAM (SDRAM). Memory 616 or 618 are representative of memory 204 and/or memories 106a-106d. In the present embodiment, the memory 616 and the memory 618 locally attach to the respective processors (e.g., processor 604 and processor 606). In other embodiments, the main memory may couple with the processors via a bus and shared memory hub. In some embodiments, memory 616 and 618 couple with the processor 604, 606 via the CXL and memory complex 208, which includes the switch 104 and the memories 106a-106d. Processor 604 includes registers 612 and processor 606 includes registers 614.

System 600 includes chipset 632 coupled to processor 604 and processor 606. Furthermore, chipset 632 can be coupled to storage device 650, for example, via an interface (I/F) 638. The I/F 638 may be, for example, a Peripheral Component Interconnect-enhanced (PCIe) interface, a Compute Express Link ^{®} (CXL) interface, or a Universal Chiplet Interconnect Express (UCIe) interface. Storage device 650 can store instructions executable by circuitry of system 600 (e.g., processor 604, processor 606, GPU 648, accelerator 206, vision processing unit 654, or the like). For example, storage device 650 can store instructions for the OS 210, caching home agent 224 error monitor 230, RAS logic 232, platform 218, or the like.

Processor 604 couples to the chipset 632 via P2P interface 628 and P2P 634 while processor 606 couples to the chipset 632 via P2P interface 630 and P2P 636. Direct media interface (DMI) 674 and DMI 676 may couple the P2P interface 628 and the P2P 634 and the P2P interface 630 and P2P 636, respectively. DMI 674 and DMI 676 may be a highspeed interconnect that facilitates, e.g., eight Giga Transfers per second (GT/s) such as DMI 3.0. In other embodiments, the processor 604 and processor 606 may interconnect via a bus.

The chipset 632 may comprise a controller hub such as a platform controller hub (PCH). The chipset 632 may include a system clock to perform clocking functions and include interfaces for an I/O bus such as a universal serial bus (USB), peripheral component interconnects (PCIs), CXL interconnects, UCIe interconnects, interface serial peripheral interconnects (SPIs), integrated interconnects (I2Cs), and the like, to facilitate connection of peripheral devices on the platform. In other embodiments, the chipset 632 may comprise more than one controller hub such as a chipset with a memory controller hub, a graphics controller hub, and an input/output (I/O) controller hub.

In the depicted example, chipset 632 couples with a trusted platform module (TPM) 644 and UEFI, BIOS, FLASH circuitry 646 via I/F 642. The TPM 644 is a dedicated microcontroller designed to secure hardware by integrating cryptographic keys into devices. The UEFI, BIOS, FLASH circuitry 646 may provide pre-boot code.

Furthermore, chipset 632 includes the I/F 638 to couple chipset 632 with a high-performance graphics engine, such as, graphics processing circuitry or a graphics processing unit (GPU) 648. In other embodiments, the system 600 may include a flexible display interface (FDI) (not shown) between the processor 604 and/or the processor 606 and the chipset 632. The FDI interconnects a graphics processor core in one or more of processor 604 and/or processor 606 with the chipset 632.

Additionally, accelerator 206 and/or vision processing unit 654 can be coupled to chipset 632 via I/F 638. The accelerator 206 is representative of any type of accelerator device (e.g., a data streaming accelerator, cryptographic accelerator, cryptographic coprocessor, an offload engine, etc.). As stated, example of an accelerator 206 is the Intel^{®} Data Streaming Accelerator (DSA). The accelerator 206 may be a device including circuitry to accelerate copy operations, data encryption, hash value computation, data comparison operations (including comparison of data in memory 616 and/or memory 618), and/or data compression. For example, the accelerator 206 may be a USB device, PCI device, PCIe device, CXL device, UCIe device, and/or an SPI device. The accelerator 206 can also include circuitry arranged to execute machine learning (ML) related operations (e.g., training, inference, etc.) for ML models. Generally, the accelerator 206 may be specially designed to perform computationally intensive operations, such as hash value computations, comparison operations, cryptographic operations, and/or compression operations, in a manner that is more efficient than when performed by the processor 604 or processor 606. Because the load of the system 600 may include hash value computations, comparison operations, cryptographic operations, and/or compression operations, the accelerator 206 can greatly increase performance of the system 600 for these operations.

The accelerator 206 may include one or more dedicated work queues and one or more shared work queues (each not pictured). Generally, a shared work queue is configured to store descriptors submitted by multiple software entities. The software may be any type of executable code, such as a process, a thread, an application, a virtual machine, a container, a microservice, etc., that share the accelerator 206. For example, the accelerator 206 may be shared according to the Single Root I/O virtualization (SR-IOV) architecture and/or the Scalable I/O virtualization (S-IOV) architecture. Embodiments are not limited in these contexts. In some embodiments, software uses an instruction to atomically submit the descriptor to the accelerator 206 via a non-posted write (e.g., a deferred memory write (DMWr)). One example of an instruction that atomically submits a work descriptor to the shared work queue of the accelerator 206 is the ENQCMD command or instruction (which may be referred to as "ENQCMD" herein) supported by the Intel^{®} Instruction Set Architecture (ISA). However, any instruction having a descriptor that includes indications of the operation to be performed, a source virtual address for the descriptor, a destination virtual address for a device-specific register of the shared work queue, virtual addresses of parameters, a virtual address of a completion record, and an identifier of an address space of the submitting process is representative of an instruction that atomically submits a work descriptor to the shared work queue of the accelerator 206. The dedicated work queue may accept job submissions via commands such as the movdir64b instruction.

The system 600 is operable to communicate with wired and wireless devices or entities via the network interface 678 using the IEEE 802 family of standards, such as wireless devices operatively disposed in wireless communication (e.g., IEEE 802.11 over-the-air modulation techniques). This includes at least Wi-Fi (or Wireless Fidelity), WiMax, and Bluetooth^{™} wireless technologies, 3G, 4G, LTE wireless technologies, among others. Thus, the communication can be a predefined structure as with a conventional network or simply an ad hoc communication between at least two devices. Wi-Fi networks use radio technologies called IEEE 802.11x (a, b, g, n, ac, ax, etc.) to provide secure, reliable, fast wireless connectivity. A Wi-Fi network can be used to connect computers to each other, to the Internet, and to wired networks (which use IEEE 802.3-related media and functions).

Various I/O devices 658 and display 652 couple to the bus 670, along with a bus bridge 656 which couples the bus 670 to a second bus 672 and an I/F 640 that connects the bus 670 with the chipset 632. In one embodiment, the second bus 672 may be a low pin count (LPC) bus. Various devices may couple to the second bus 672 including, for example, a keyboard 660, a mouse 662 and communication devices 664.

Furthermore, an audio I/O 666 may couple to second bus 672. Many of the I/O devices 658 and communication devices 664 may reside on the system-on-chip (SoC) 602 while the keyboard 660 and the mouse 662 may be add-on peripherals. In other embodiments, some or all the I/O devices 658 and communication devices 664 are add-on peripherals and do not reside on the system-on-chip (SoC) 602.

The components and features of the devices described above may be implemented using any combination of discrete circuitry, application specific integrated circuits (ASICs), logic gates and/or single chip architectures. Further, the features of the devices may be implemented using microcontrollers, programmable logic arrays and/or microprocessors or any combination of the foregoing where suitably appropriate. It is noted that hardware, firmware and/or software elements may be collectively or individually referred to herein as "logic" or "circuit."

It will be appreciated that the exemplary devices shown in the block diagrams described above may represent one functionally descriptive example of many potential implementations. Accordingly, division, omission or inclusion of block functions depicted in the accompanying figures does not infer that the hardware components, circuits, software and/or elements for implementing these functions would necessarily be divided, omitted, or included in embodiments.

At least one computer-readable storage medium may include instructions that, when executed, cause a system to perform any of the computer-implemented methods described herein.

Some embodiments may be described using the expression "one embodiment" or "an embodiment" along with their derivatives. These terms mean that a particular feature, structure, or characteristic described in connection with the embodiment is included in at least one embodiment. The appearances of the phrase "in one embodiment" in various places in the specification are not necessarily all referring to the same embodiment. Moreover, unless otherwise noted the features described above are recognized to be usable together in any combination. Thus, any features discussed separately may be employed in combination with each other unless it is noted that the features are incompatible with each other.

With general reference to notations and nomenclature used herein, the detailed descriptions herein may be presented in terms of program procedures executed on a computer or network of computers. These procedural descriptions and representations are used by those skilled in the art to most effectively convey the substance of their work to others skilled in the art.

A procedure is here, and generally, conceived to be a self-consistent sequence of operations leading to a desired result. These operations are those requiring physical manipulations of physical quantities. Usually, though not necessarily, these quantities take the form of electrical, magnetic or optical signals capable of being stored, transferred, combined, compared, and otherwise manipulated. It proves convenient at times, principally for reasons of common usage, to refer to these signals as bits, values, elements, symbols, characters, terms, numbers, or the like. It should be noted, however, that all of these and similar terms are to be associated with the appropriate physical quantities and are merely convenient labels applied to those quantities.

Further, the manipulations performed are often referred to in terms, such as adding or comparing, which are commonly associated with mental operations performed by a human operator. No such capability of a human operator is necessary, or desirable in most cases, in any of the operations described herein, which form part of one or more embodiments. Rather, the operations are machine operations. Useful machines for performing operations of various embodiments include general purpose digital computers or similar devices.

Some embodiments may be described using the expression "coupled" and "connected" along with their derivatives. These terms are not necessarily intended as synonyms for each other. For example, some embodiments may be described using the terms "connected" and/or "coupled" to indicate that two or more elements are in direct physical or electrical contact with each other. The term "coupled," however, may also mean that two or more elements are not in direct contact with each other, but yet still co-operate or interact with each other.

Various embodiments also relate to apparatus or systems for performing these operations. This apparatus may be specially constructed for the required purpose or it may comprise a general purpose computer as selectively activated or reconfigured by a computer program stored in the computer. The procedures presented herein are not inherently related to a particular computer or other apparatus. Various general purpose machines may be used with programs written in accordance with the teachings herein, or it may prove convenient to construct more specialized apparatus to perform the required method steps. The required structure for a variety of these machines will appear from the description given.

What has been described above includes examples of the disclosed architecture. It is, of course, not possible to describe every conceivable combination of components and/or methodologies, but one of ordinary skill in the art may recognize that many further combinations and permutations are possible. Accordingly, the novel architecture is intended to embrace all such alterations, modifications and variations that fall within the spirit and scope of the appended claims.

The various elements of the devices as previously described with reference to FIGS. 1-6 may include various hardware elements, software elements, or a combination of both. Examples of hardware elements may include devices, logic devices, components, processors, microprocessors, circuits, processors, circuit elements (e.g., transistors, resistors, capacitors, inductors, and so forth), integrated circuits, application specific integrated circuits (ASIC), programmable logic devices (PLD), digital signal processors (DSP), field programmable gate array (FPGA), memory units, logic gates, registers, semiconductor device, chips, microchips, chip sets, and so forth. Examples of software elements may include software components, programs, applications, computer programs, application programs, system programs, software development programs, machine programs, operating system software, middleware, firmware, software modules, routines, subroutines, functions, methods, procedures, software interfaces, application program interfaces (API), instruction sets, computing code, computer code, code segments, computer code segments, words, values, symbols, or any combination thereof. However, determining whether an embodiment is implemented using hardware elements and/or software elements may vary in accordance with any number of factors, such as desired computational rate, power levels, heat tolerances, processing cycle budget, input data rates, output data rates, memory resources, data bus speeds and other design or performance constraints, as desired for a given implementation.

One or more aspects of at least one embodiment may be implemented by representative instructions stored on a machine-readable medium which represents various logic within the processor, which when read by a machine causes the machine to fabricate logic to perform the techniques described herein. Such representations, known as "IP cores" may be stored on a tangible, machine readable medium and supplied to various customers or manufacturing facilities to load into the fabrication machines that make the logic or processor. Some embodiments may be implemented, for example, using a machine-readable medium or article which may store an instruction or a set of instructions that, if executed by a machine, may cause the machine to perform a method and/or operations in accordance with the embodiments. Such a machine may include, for example, any suitable processing platform, computing platform, computing device, processing device, computing system, processing system, computer, processor, or the like, and may be implemented using any suitable combination of hardware and/or software. The machine-readable medium or article may include, for example, any suitable type of memory unit, memory device, memory article, memory medium, storage device, storage article, storage medium and/or storage unit, for example, memory, removable or non-removable media, erasable or non-erasable media, writeable or re-writeable media, digital or analog media, hard disk, floppy disk, Compact Disk Read Only Memory (CD-ROM), Compact Disk Recordable (CD-R), Compact Disk Rewriteable (CD-RW), optical disk, magnetic media, magneto-optical media, removable memory cards or disks, various types of Digital Versatile Disk (DVD), a tape, a cassette, or the like. The instructions may include any suitable type of code, such as source code, compiled code, interpreted code, executable code, static code, dynamic code, encrypted code, and the like, implemented using any suitable high-level, low-level, object-oriented, visual, compiled and/or interpreted programming language.

It will be appreciated that the exemplary devices shown in the block diagrams described above may represent one functionally descriptive example of many potential implementations. Accordingly, division, omission or inclusion of block functions depicted in the accompanying figures does not infer that the hardware components, circuits, software and/or elements for implementing these functions would necessarily be divided, omitted, or included in embodiments.

At least one computer-readable storage medium may include instructions that, when executed, cause a system to perform any of the computer-implemented methods described herein.

Some embodiments may be described using the expression "one embodiment" or "an embodiment" along with their derivatives. These terms mean that a particular feature, structure, or characteristic described in connection with the embodiment is included in at least one embodiment. The appearances of the phrase "in one embodiment" in various places in the specification are not necessarily all referring to the same embodiment. Moreover, unless otherwise noted the features described above are recognized to be usable together in any combination. Thus, any features discussed separately may be employed in combination with each other unless it is noted that the features are incompatible with each other.

The following examples pertain to further embodiments, from which numerous permutations and configurations will be apparent.

Example 1 includes an apparatus, comprising: an interface to a memory pool; and a processor operable to execute one or more instructions to cause the processor to: determine a first memory region of a plurality of memory regions in the memory pool; and modify a metadata of the first memory region from a first configuration to a second configuration, wherein the first configuration is associated with a first number of error correction code (ECC) bits and the second configuration is associated with a second number of ECC bits.

Example 2 includes the subject matter of example 1, wherein the first number of ECC bits is different than the second number of ECC bits.

Example 3 includes the subject matter of example 1, wherein the first configuration is associated with a first number of bits for a service, wherein the second configuration is associated with a second number of bits for the service.

Example 4 includes the subject matter of example 3, wherein the service is to comprise one or more of a security service, an encryption service, an isolation service, or an interconnect protocol service.

Example 5 includes the subject matter of example 1, the processor operable to execute the one or more instructions to cause the processor to, prior to modifying the metadata: receive a request to modify the metadata of the first memory region.

Example 6 includes the subject matter of example 1, the processor operable to execute the one or more instructions to cause the processor to, prior to modifying the metadata: determine an error rate of the first memory region; and determine to modify the metadata of the first memory region based on the error rate.

Example 7 includes the subject matter of example 1, the processor operable to execute the one or more instructions to cause the processor to: determine a Quality of Service (QoS) parameter for the first memory region; and migrate the first memory region to a second memory region of the plurality of memory regions based on the QoS parameter for the first memory region.

Example 8 includes the subject matter of example 1, the processor operable to execute the one or more instructions to cause the processor to: determine a Quality of Service (QoS) parameter for the first memory region; and modify the first memory region to include a second memory region of the plurality of memory regions based on the QoS parameter for the first memory region.

Example 9 includes the subject matter of example 1, wherein the interface to the memory pool is to be based on the Compute Express Link standard.

Example 10 includes the subject matter of example 1, further comprising a memory controller configured to, subsequent to the modification of the metadata: determine, based on the second number of ECC bits, one or more ECC bits in the metadata for a first memory line of the first memory region; compute an ECC value based on the first memory line of the first memory region; and compare the ECC value to the one or more ECC bits in the metadata for the first memory line of the first memory region.

Example 11 includes an method, comprising: determining, by a processor, a first memory region of a plurality of memory regions in a memory pool coupled to the processor via an interface; and modifying, by the processor, a metadata of the first memory region from a first configuration to a second configuration, wherein the first configuration is associated with a first number of error correction code (ECC) bits and the second configuration is associated with a second number of ECC bits.

Example 12 includes the subject matter of example 11, wherein the first number of ECC bits is different than the second number of ECC bits.

Example 13 includes the subject matter of example 11, wherein the first configuration is associated with a first number of bits for a service, wherein the second configuration is associated with a second number of bits for the service.

Example 14 includes the subject matter of example 13, wherein the service is to comprise one or more of a security service, an encryption service, an isolation service, or an interconnect protocol service.

Example 15 includes the subject matter of example 11, further comprising prior to modifying the metadata: receiving, by the processor, a request to modify the metadata of the first memory region.

Example 16 includes the subject matter of example 11, further comprising prior to modifying the metadata: determining, by the processor, an error rate of the first memory region; and determining, by the processor, to modify the metadata of the first memory region based on the error rate.

Example 17 includes the subject matter of example 11, further comprising: determining, by the processor, a Quality of Service (QoS) parameter for the first memory region; and migrating, by the processor, the first memory region to a second memory region of the plurality of memory regions based on the QoS parameter for the first memory region.

Example 18 includes the subject matter of example 11, further comprising: determining, by the processor, a Quality of Service (QoS) parameter for the first memory region; and modifying, by the processor, the first memory region to include a second memory region of the plurality of memory regions based on the QoS parameter for the first memory region.

Example 19 includes the subject matter of example 11, wherein the interface to the memory pool is to be based on the Compute Express Link standard.

Example 20 includes the subject matter of example 11, further comprising subsequent to modifying the metadata: determining, by a memory controller, based on the second number of ECC bits, one or more ECC bits in the metadata for a first memory line of the first memory region; computing, by the memory controller, an ECC value based on the first memory line of the first memory region; and comparing, by the memory controller, the ECC value to the one or more ECC bits in the metadata for the first memory line of the first memory region.

Example 21 includes a non-transitory computer-readable storage medium storing instructions that when executed by a processor cause the processor to: determine a first memory region of a plurality of memory regions in a memory pool; and modify a metadata of the first memory region from a first configuration to a second configuration, wherein the first configuration is associated with a first number of error correction code (ECC) bits and the second configuration is associated with a second number of ECC bits.

Example 22 includes the subject matter of example 21, wherein the first number of ECC bits is different than the second number of ECC bits.

Example 23 includes the subject matter of example 21, wherein the first configuration is associated with a first number of bits for a service, wherein the second configuration is associated with a second number of bits for the service.

Example 24 includes the subject matter of example 21, wherein the service is to comprise one or more of a security service, an encryption service, an isolation service, or an interconnect protocol service.

Example 25 includes the subject matter of example 21, storing instructions that when executed by the processor cause the processor to, prior to modifying the metadata: receive a request to modify the metadata of the first memory region.

Example 26 includes the subject matter of example 21, storing instructions that when executed by the processor cause the processor to: determine a Quality of Service (QoS) parameter for the first memory region; and modify the first memory region to include a second memory region of the plurality of memory regions based on the QoS parameter for the first memory region.

Example 27 includes the subject matter of example 21, storing instructions that when executed by the processor cause the processor to: determine a Quality of Service (QoS) parameter for the first memory region; and migrate the first memory region to a second memory region of the plurality of memory regions based on the QoS parameter for the first memory region.

Example 28 includes the subject matter of example 21, storing instructions that when executed by the processor cause the processor to: determine a Quality of Service (QoS) parameter for the first memory region; and migrate the first memory region to include a second memory region of the plurality of memory regions based on the QoS parameter for the first memory region.

Example 29 includes the subject matter of example 21, wherein an interface to the memory pool is to be based on the Compute Express Link standard.

Example 30 includes the subject matter of example 21, storing instructions that when executed by the processor cause the processor to: determine, by a memory controller based on the second number of ECC bits, one or more ECC bits in the metadata for a first memory line of the first memory region; compute, by the memory controller, an ECC value based on the first memory line of the first memory region; and compare, by the memory controller, the ECC value to the one or more ECC bits in the metadata for the first memory line of the first memory region.

Example 31 includes an apparatus, comprising: means for determining a first memory region of a plurality of memory regions in a memory pool coupled to the processor via an interface; and means for modifying a metadata of the first memory region from a first configuration to a second configuration, wherein the first configuration is associated with a first number of error correction code (ECC) bits and the second configuration is associated with a second number of ECC bits.

Example 32 includes the subject matter of example 31, wherein the first number of ECC bits is different than the second number of ECC bits.

Example 33 includes the subject matter of example 31, wherein the first configuration is associated with a first number of bits for a service, wherein the second configuration is associated with a second number of bits for the service.

Example 34 includes the subject matter of example 33, wherein the service is to comprise one or more of a security service, an encryption service, an isolation service, or an interconnect protocol service.

Example 35 includes the subject matter of example 31, further comprising prior to modifying the metadata: means for receiving a request to modify the metadata of the first memory region

Example 36 includes the subject matter of example 31, further comprising prior to modifying the metadata: means for determining an error rate of the first memory region; and means for determining to modify the metadata of the first memory region based on the error rate.

Example 37 includes the subject matter of example 31, further comprising: means for determining a Quality of Service (QoS) parameter for the first memory region; and means for migrating the first memory region to a second memory region of the plurality of memory regions based on the QoS parameter for the first memory region.

Example 38 includes the subject matter of example 31, further comprising: means for determining a Quality of Service (QoS) parameter for the first memory region; and means for modifying the first memory region to include a second memory region of the plurality of memory regions based on the QoS parameter for the first memory region

Example 39 includes the subject matter of example 31, wherein the interface to the memory pool is to be based on the Compute Express Link standard.

Example 40 includes the subject matter of example 31, further comprising subsequent to modifying the metadata: means for determining, based on the second number of ECC bits, one or more ECC bits in the metadata for a first memory line of the first memory region; means for computing an ECC value based on the first memory line of the first memory region; and means for comparing the ECC value to the one or more ECC bits in the metadata for the first memory line of the first memory region.

Example 41 includes a non-transitory computer-readable storage medium storing instructions that when executed by a processor cause the processor to: map a first address space of a plurality of address spaces to a first set of memory features, wherein the first set of memory features includes a first number of error correction code (ECC) bits; and map a second address space of the plurality of address spaces to a second set of memory features, wherein the second set of memory features includes a second number of ECC bits, wherein the second number of ECC bits is different than the first number of ECC bits.

Example 42 includes the subject matter of example 41, wherein the first set of memory features is associated with a first number of bits for a service, wherein the second set of memory features is associated with a second number of bits for the service.

Example 43 includes the subject matter of example 41, wherein the service is to comprise one or more of a security service, an encryption service, an isolation service, or an interconnect protocol service.

Example 44 includes an method, comprising: mapping, by a processor, a first address space of a plurality of address spaces to a first set of memory features, wherein the first set of memory features includes a first number of error correction code (ECC) bits; and map, by the processor, a second address space of the plurality of address spaces to a second set of memory features, wherein the second set of memory features includes a second number of ECC bits, wherein the second number of ECC bits is different than the first number of ECC bits.

Example 45 includes the subject matter of example 44, wherein the first set of memory features is associated with a first number of bits for a service, wherein the second set of memory features is associated with a second number of bits for the service.

Example 46 includes the subject matter of example 45, wherein the service is to comprise one or more of a security service, an encryption service, an isolation service, or an interconnect protocol service.

Example 47 includes computing apparatus comprising: a processor; and a memory storing instructions that, when executed by the processor, configure the apparatus to: map a first address space of a plurality of address spaces to a first set of memory features, wherein the first set of memory features includes a first number of error correction code (ECC) bits; and map a second address space of the plurality of address spaces to a second set of memory features, wherein the second set of memory features includes a second number of ECC bits, wherein the second number of ECC bits is different than the first number of ECC bits.

Example 48 includes the subject matter of example 47, wherein the first set of memory features is associated with a first number of bits for a service, wherein the second set of memory features is associated with a second number of bits for the service.

Example 49 includes the subject matter of example 48, wherein the service is to comprise one or more of a security service, an encryption service, an isolation service, or an interconnect protocol service.

Example 50 includes an apparatus, comprising: means for mapping a first address space of a plurality of address spaces to a first set of memory features, wherein the first set of memory features includes a first number of error correction code (ECC) bits; and means for map a second address space of the plurality of address spaces to a second set of memory features, wherein the second set of memory features includes a second number of ECC bits, wherein the second number of ECC bits is different than the first number of ECC bits.

Example 51 includes the subject matter of example 50, wherein the first set of memory features is associated with a first number of bits for a service, wherein the second set of memory features is associated with a second number of bits for the service.

Example 52 includes the subject matter of example 51, wherein the service is to comprise one or more of a security service, an encryption service, an isolation service, or an interconnect protocol service.

It is emphasized that the Abstract of the Disclosure is provided to allow a reader to quickly ascertain the nature of the technical disclosure. It is submitted with the understanding that it will not be used to interpret or limit the scope or meaning of the claims. In addition, in the foregoing Detailed Description, it can be seen that various features are grouped together in a single embodiment for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus the following claims are hereby incorporated into the Detailed Description, with each claim standing on its own as a separate embodiment. In the appended claims, the terms "including" and "in which" are used as the plain-English equivalents of the respective terms "comprising" and "wherein," respectively. Moreover, the terms "first," "second," "third," and so forth, are used merely as labels, and are not intended to impose numerical requirements on their objects.

The foregoing description of example embodiments has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto. Future filed applications claiming priority to this application may claim the disclosed subject matter in a different manner, and may generally include any set of one or more limitations as variously disclosed or otherwise demonstrated herein.

## Claims

1. A method, comprising:
determining, by a processor, a first memory region of a plurality of memory regions in a memory pool coupled to the processor via an interface; and
modifying, by the processor, a metadata of the first memory region from a first configuration to a second configuration, wherein the first configuration is associated with a first number of error correction code (ECC) bits and the second configuration is associated with a second number of ECC bits.

2. The method of claim 1, wherein the first number of ECC bits is different than the second number of ECC bits.

3. The method of claim 1, wherein the first configuration is associated with a first number of bits for a service, wherein the second configuration is associated with a second number of bits for the service.

4. The method of claim 3, wherein the service is to comprise one or more of a security service, an encryption service, an isolation service, or an interconnect protocol service.

5. The method of claim 1, further comprising prior to modifying the metadata:
receiving, by the processor, a request to modify the metadata of the first memory region.

6. The method of claim 1, further comprising prior to modifying the metadata:
determining, by the processor, an error rate of the first memory region; and
determining, by the processor, to modify the metadata of the first memory region based on the error rate.

7. The method of claim 1, further comprising:
determining, by the processor, a Quality of Service (QoS) parameter for the first memory region; and
migrating, by the processor, the first memory region to a second memory region of the plurality of memory regions based on the QoS parameter for the first memory region.

8. The method of claim 1, further comprising:
determining, by the processor, a Quality of Service (QoS) parameter for the first memory region; and
modifying, by the processor, the first memory region to include a second memory region of the plurality of memory regions based on the QoS parameter for the first memory region.

9. The method of claim 1, wherein the interface to the memory pool is to be based on the Compute Express Link standard.

10. The method of claim 1, further comprising subsequent to modifying the metadata:
determining, by a memory controller, based on the second number of ECC bits, one or more ECC bits in the metadata for a first memory line of the first memory region;
computing, by the memory controller, an ECC value based on the first memory line of the first memory region; and
comparing, by the memory controller, the ECC value to the one or more ECC bits in the metadata for the first memory line of the first memory region.

11. An apparatus comprising means to perform a method as claimed in any preceding claim.

12. A computer program comprising instructions which, when the program is executed by a computer, cause the computer to carry out the method as claimed in any preceding claim.

13. Machine-readable storage including machine-readable instructions, when executed, to implement a method or realize an apparatus as claimed in any preceding claim.
